# EUROPEAN PATENT SPECIFICATION

(11) **EP 2 775 512 B1**
(45) Date of publication and mention of the grant of the patent: **26.02.2025**
(21) Application number: 14157382.4
(22) Date of filing: 28.02.2014
(51) Int. Cl.: H01L 21/60, H01L 25/065, H01L 25/18, H01L 23/538, H01L 23/498

(54) **Semiconductor devices**
Halbleiterbauelemente
Dispositifs semi-conducteurs

(30) Priority: 06.03.2013 US 201313786538
(43) Date of publication of application: 10.09.2014
(73) Proprietor: Intel Deutschland GmbH, 85579 Neubiberg (DE)
(72) Inventor: Barth, Hans-Joachim, 81245 München (DE); Mahnkopf, Reinhard, 82041 Oberhaching (DE); Meyer, Thorsten, 93053 Regensburg (DE); Albers, Sven, 93049 Regensburg (DE); Augustin, Andreas, 81825 München (DE); Müller, Christian, 46242 Bottrop (DE)
(74) Representative: Rummler, Felix

(56) References cited:
- KR-A- 20110 048 733
- US-A1- 2012 077 313

## Description

### Technical Field

The present disclosure relates generally to semiconductor devices.

### Background

In three-dimensional (3D) chip stacks, two or more semiconductor chips may be stacked on top of each other. Adjacent chips in the stack may be electrically coupled to one another via an interface. The physical design of the interface may be predetermined or fixed according to a given standard. For example, geometric dimensions of the interface, such as length, width, pad pitch, etc., may be prescribed by the standard. For example with increasing scaling in semiconductor technology, chip sizes may come close to or become even smaller than the prescribed geometric dimensions of the interface. For example, a chip may have a length that is smaller than a length of the interface as prescribed by the standard. In this case, it may be desirable to modify the chip to fit to the partly larger interface. US 2012/0077313 A1 describes a semiconductor device having a plurality of mold-sealed semiconductor chips connected to a flip chip-mounted semiconductor chip by rewiring and an insulating layer. KR 2011 0048733 A describes a stack chip package using RDL and TSV to make a device thin by forming a plurality of memory chips which are laminated in the upper corner of a lower chip and reducing the thickness of the device.

### Summary

A semiconductor device is provided as set out in claim 1.

### Brief Description of the Drawings

In the drawings, like reference characters generally refer to the same parts throughout the different views. The drawings are not necessarily to scale, emphasis instead generally being placed upon illustrating the principles of the invention. In the following description, various aspects are described with reference to the following drawings, in which:
Fig. 1 is a cross-sectional view of a conventional three-dimensional (3D) logic-memory stack;
Fig. 2 is a plan view of the standardized JEDEC 'wide I/O' interface on a typical 'wide I/O' DRAM memory;
Fig. 3 is a plan view to illustrate a conventional approach to increase the chip size of a small logic chip to fit to the 'wide I/O' interface;
Fig. 4 is a plan view of an example of a semiconductor device of the claimed invention in accordance with one or more aspects described herein, including an extension layer extending laterally from a boundary of a first semiconductor chip of the semiconductor device;
Fig. 5 is a plan view of an example of a semiconductor device of the claimed invention, including an extension layer extending from two opposite lateral sides of the first semiconductor chip;
Fig. 6 is a plan view of an example of a semiconductor device of the claimed invention, including an extension layer extending from one lateral side of the first semiconductor chip;
Fig. 7 is a plan view of an example of a semiconductor device of the claimed invention, including a redistribution layer for rerouting interface connections disposed outside a boundary of the first semiconductor chip to electrically conductive contacts inside the boundary of the first semiconductor chip;
Fig. 8 is a cross-sectional view of an example of a semiconductor device of the claimed invention configured as a three-dimensional (3D) logic-memory stack;
Fig. 9 is a cross-sectional view of an example of a semiconductor device of the claimed invention, including a redistribution layer disposed over a back side and a front side of a first semiconductor chip and through-vias for rerouting interface connections;
Fig. 10 is a plan view of an example of a semiconductor device of the claimed invention, including a redistribution layer disposed over a back side and a front side of a first semiconductor chip and through-vias for rerouting interface connections.

### Description

The following detailed description refers to the accompanying drawings that show, by way of illustration, specific details and aspects of this disclosure in which the invention may be practiced. These aspects of this disclosure are described in sufficient detail to enable those skilled in the art to practice the invention. Other aspects of this disclosure may be utilized and structural, logical, and electrical changes may be made without departing from the scope of the invention. The various aspects of this disclosure are not necessarily mutually exclusive, as some aspects of this disclosure can be combined with one or more other aspects of this disclosure to form new aspects.

The word "over", used herein to describe forming a feature, e.g. a layer "over" a side or surface, may be used to mean that the feature, e.g. the layer, may be disposed or formed "directly on", e.g. in direct contact with, the implied side or surface. The word "over", used herein to describe forming a feature, e.g. a layer "over" a side or surface, may be used to mean that the feature, e.g. the layer, may be disposed or formed "indirectly on" the implied side or surface with one or more additional layers being arranged between the implied side or surface and the formed layer.

The terms "coupled" and/or "electrically coupled" and/or "connected" and/or "electrically connected", used herein to describe a feature being connected to at least one other implied feature, are not meant to mean that the feature and the at least one other implied feature must be directly coupled or connected together; intervening features may be provided between the feature and at least one other implied feature.

The terms "at least one" and "one or more" may be understood to include any integer number greater than or equal to one, i.e. "one", "two", three", "four", etc.

The term "a plurality of" may be understood to include any integer number greater than or equal to two, i.e. "two", "three", "four", "five", etc.

The term "standardized" as used herein may, for example, be understood as meaning "according to a standard" or "defined by a standard", for example according to or defined by a standard developed by a standardization committee, body or organization such as JEDEC (Joint Electron Device Engineering Council) or others.

In one or more aspects, the present disclosure relates to three-dimensional (3D) chip stacks such as, for example, stacks of logic and memory chips. The following description will mainly refer to logic/memory chip stacks as an example, however the present disclosure is not limited to this case and may be applied to stacking of any two or more chips in general. For example, the stacking of logic chips on logic chips; the stacking of logic chips with RF chips, analog/mixed signal chips or power chips; the stacking of chips with sensors, with micro electro mechanical systems (MEMS) or CMOS image sensors, and any other combination of 3D stacks.

Memory chips or a stack of memory chips may, for example, include or consist of dynamic random access memory (DRAM) memory chips with a 'Wide I/O (Input/Output)' interface (JEDEC standard). As will be readily understood, the present disclosure may not be limited to this particular case.

One important aspect of 3D logic/memory chip stacks with 'wide I/O' interface is the fact that the size of the logic/memory interface is fixed to 0.52 mm × 5.25 mm according to the JEDEC standard.

However, especially in mobile applications many logic chips (especially in future technology nodes beyond 28 nm) may have a chip size that may come close to or even smaller as compared to the length (5.25 mm) of the 'wide I/O' standard. Therefore a cost effective solution may be needed to modify a small logic chip to fit to the partly larger 'wide I/O' interface stacked on top.

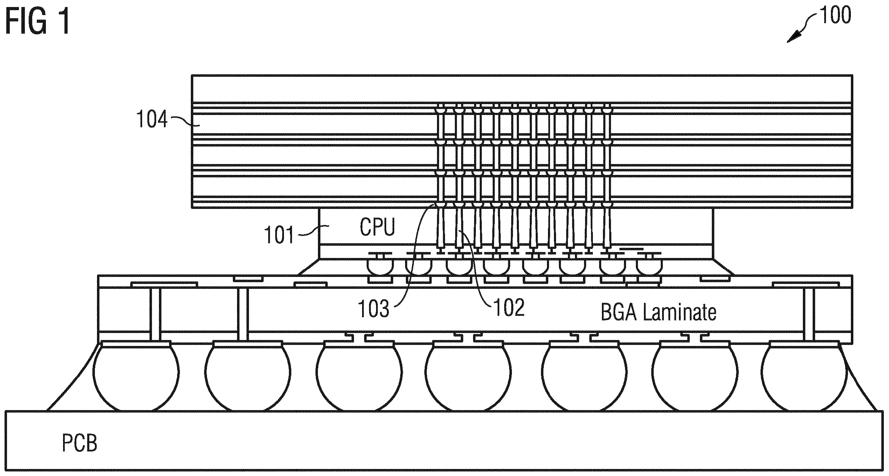

As shown in Fig. 1 in a cross-sectional view 100, a 3D logic memory stack for e.g. mobile applications may include a logic chip 101 (e.g. CPU, etc.) with TSVs (through-silicon vias) 102 connected by a 'wide I/O interface' 103 to a single memory chip or a stack of memory chips 104. Typically, this 3D logic/memory chip stack may be connected to a (multi-layer) ball grid array (BGA) laminate package by flip-chip connections, as shown in Fig. 1. In the 3D logic memory stack shown in Fig. 1, the size of the logic chip 101 is larger than the extension of the 'wide I/O' interface 103 (e.g. here with µ-bumps and TSVs).

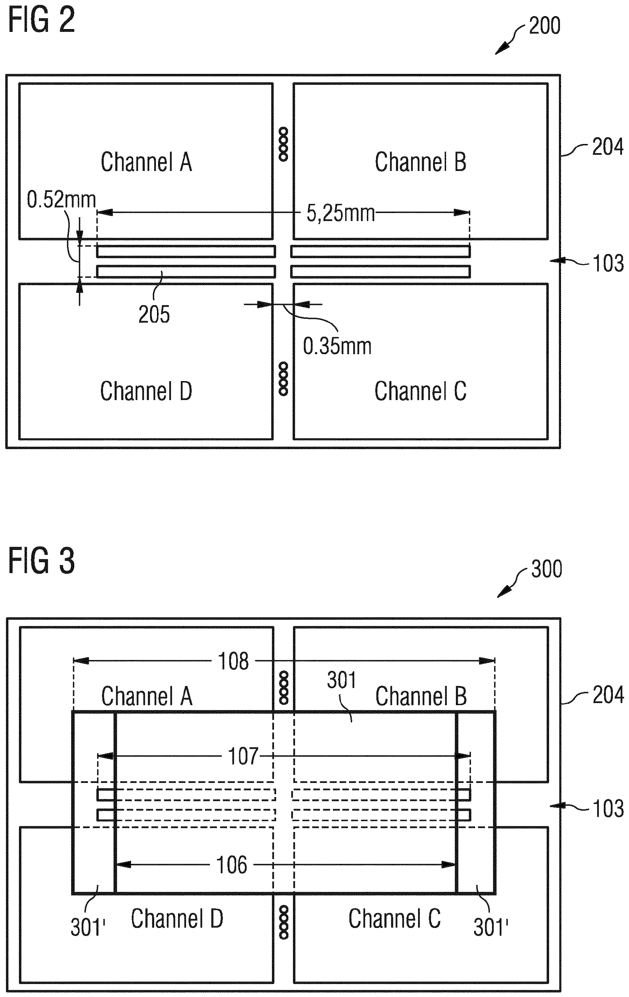

Fig. 2 shows in a plan view 200 the standardized JEDEC 'wide I/O' logic-memory interface (LMI) 103 on a typical 'wide I/O' DRAM memory 204. The 'wide I/O' interface 103 may include a high density contact grid 205 including a plurality of electrically conductive contacts.

Details of the 'wide I/O' interface of a typical DRAM memory, such as memory 204, as defined by the JEDEC standard, include, for example:
- 'Wide I/O' may define 4 memory channels on the LMI ("channel A", "channel B", "channel C", and "channel D" in Fig. 2).
- Each channel may be 128 data bits wide, resulting in 512 bits total;
- Each channel may include all control, power and ground for the channel; power connections may be shared between channels;
- Each channel may be independently controlled, e.g. independent control, clock and data;
- Each channel may have 300 connections, arranged in 6 rows × 50 columns, resulting in a total of 1200 connections in all 4 channels;
- Pin locations may be symmetric between channels;
- 1.2 V CMOS signal levels may be used, with no termination;
- Pad pitch may be 40 µm × 50 µm;
- Total LMI dimension may be 0.52 mm × 5.25 mm (as shown in Fig. 2).

That is, the 'wide I/O' interface according to the JEDEC standard may have a length of 5.25 mm and a width of 0.52 mm.

If, for example, the respective size of the logic chip 101 in Fig. 1 was smaller than the length of the 'wide I/O' interface 103, the interface 103 would no longer fit onto the logic chip 101. A conventional approach to address the aforementioned issue may be to increase the chip size (here length of chip) until it is long/large enough to fit to the 'wide I/O' interface standard, as is shown in Fig. 3.

Fig. 3 shows in a plan view 300 that the chip size of a small logic chip may be extended (on silicon) until it fits to the size of the 'wide I/O' interface 103, wherein reference sign 301 denotes the logic chip having the original chip size and reference sign 301' denotes the logic chip with extended chip size. As may be seen, the logic chip 301 having the original chip size has a length 106 that is shorter than a length 107 of the interface 103, whereas the logic chip 301' with extended chip size has a length 108 that is longer than the length 107 of the interface 103.

The conventional approach to extend the chip size, as shown in Fig. 3, may be extremely expensive, because it requires an additional 'dummy' chip area (that is, chip area which is not needed for active or passive circuitry) which may need to be manufactured in an expensive silicon wafer technology (e.g. beyond 28 nm node).

In one or more aspects, the present disclosure provides a relatively cheap (cost effective) way to increase the size (area) of the logic chip, or in general, of any first chip that shall be coupled to a second chip via an interface that is partly larger than the chip size of the first chip. For example, semiconductor devices in accordance with one or more aspects described herein may apply a relatively cheap (cost effective) fan-out WLP (wafer level package) or eWLB (embedded wafer level package ball grid array) approach to gain enough space for the interface or for the placement of one or more electrically conductive contacts (e.g. pads) connecting to the interface (e.g. logic-memory interface, e.g. 'wide I/O' interface).

An extension layer including or composed of a relatively cheap chip encapsulation material (e.g. a plastic material such as a molding material, or the like) is used to increase the chip size or area, and a redistribution layer (RDL) disposed over the extension layer is used to reroute one or more interface connections disposed outside (e.g. at least partially outside, e.g. fully outside) a boundary of the chip (in other words, outside the original chip area) to one or more electrically conductive contacts of the chip inside the boundary of the chip (inside the original chip area). The RDL may be a single level RDL or a multi-level RDL (i.e. an RDL having two or more levels or layers). A multi-level RDL may, for example, be used in cases where a relatively large number of interface interconnections lie outside the boundary of the chip (outside the original chip area).

According to one or more aspects, the present disclosure proposes for chips (e.g. logic chips) that are smaller than the extension of a standardized chip-to-chip interface (e.g. standardized logic-memory interface, e.g. 'wide I/O' memory interface according to JEDEC standard) to make use of a fan-out WLP (eWLB) chip extension with a single-level or multi-level RDL to provide the connection to the larger interface (e.g. memory interface). This approach may be significantly more cost effective (cheaper) than the conventional approach to increase the area of the chip, e.g. increase the silicon area of a highly advanced logic chip.

The eWLB RDL is able to reroute one or more interface connections (e.g. 'wide I/O' connections) to appropriate areas of the small chip, where the placement of a through-via (e.g. through-silicon via (TSV)) or an array of through-vias (e.g. TSVs) is possible.

The fan-out eWLB RDL may be disposed over one side (e.g. back side) of the chip only or, alternatively, may be disposed over both sides of the chip (i.e. over the back side and over the front side of the chip (e.g. logic chip)).

As an alternative to the through-via (e.g. TSV) connections on the chip (e.g. logic chip), all or a part of the connections may be provided by through-vias (e.g. through mold vias (TMVs)) extending through the extension layer (e.g. mold compound) in the fan-out area of the eWLB package. These through-vias (e.g. TMVs) in combination with the RDL levels are able to connect the interface contacts (e.g. 'wide I/O' pads) with the front side (active circuit area) of the small chip (e.g. logic chip) and to an interposer (e.g. laminate interposer) (if necessary even bypassing the small chip (e.g. logic chip)).

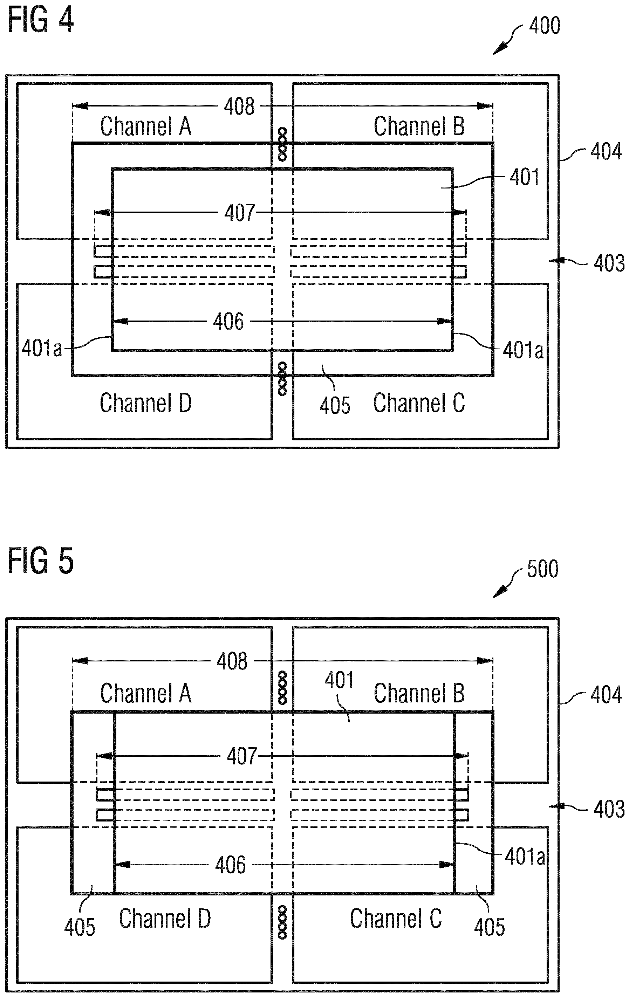

Fig. 4 is a plan view 400 of an example of a semiconductor device in accordance with one or more aspects described herein.

The semiconductor device includes a first semiconductor chip 401. According to the example shown, the first semiconductor chip 401 may be a (small) logic chip, similar to logic chip 301 in Fig. 3. However, the first semiconductor chip 401 may be another type of chip different from a logic chip, and may be any type of chip in general.

The first semiconductor chip 401 is to be electrically coupled to a second semiconductor chip 404 via a standardized chip-to-chip interface 403. According to the example shown, the second semiconductor chip 404 may be a memory chip (e.g. a DRAM chip). Accordingly, the chip-to-chip interface 403 may be a logic-memory interface, e.g. a 'wide I/O' logic-memory interface, similar to interface 103 shown in Fig. 3. However, the second semiconductor chip 404 may be another type of chip different from a memory chip, and may be any type of chip in general, and the interface 403 may be another type of interface, e.g. a different type of logic-memory interface, or a type of interface different from a logic-memory interface, and may, for example, be any type of interface having a predefined or fixed size (prescribed by some standard), which is at least partly larger than the size (area) of the first semiconductor chip 401.

As shown in Fig. 4, the first semiconductor chip 401 has a length 406 that is smaller than a length 407 of the standardized chip-to-chip interface 403. For example, in case that the chip-to-chip interface 403 is a 'wide I/O' logic-memory interface, the length 406 of the first semiconductor chip 401 may be smaller than 5.25 mm. For other types of interfaces having different dimensions, the length 406 may be smaller than some value different from 5.25 mm, as will be readily understood.

Thus, as may be seen from Fig. 4, a part of the chip-to-chip interface 403 extends laterally beyond a boundary 401a of the first semiconductor chip 401. In other words, the interface 403 does not fully fit onto the area of the first semiconductor chip 401 of the semiconductor device. In particular, the interface 403 is longer than the chip 401.

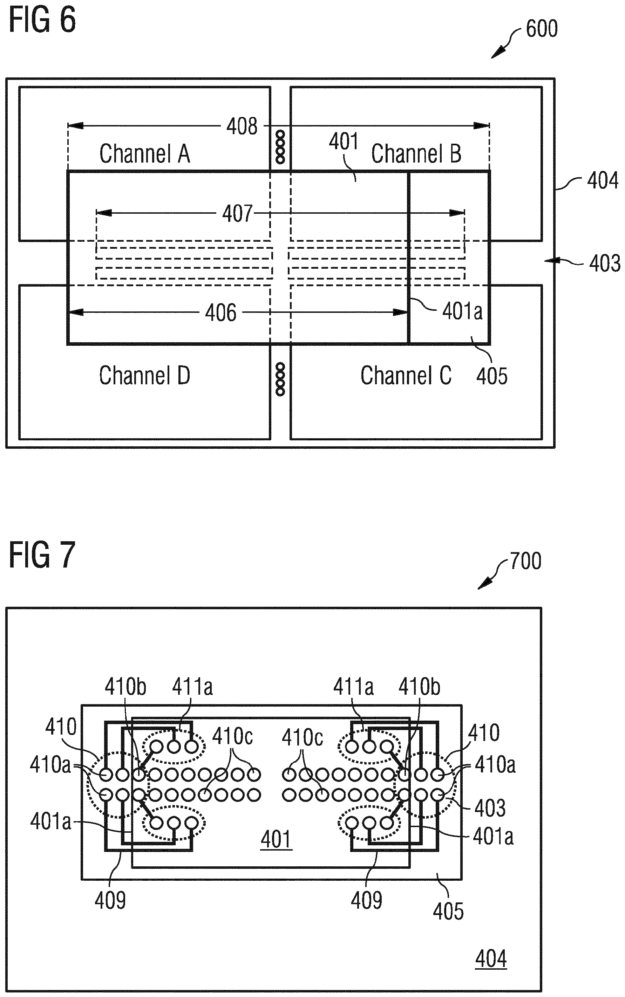

As shown, the semiconductor device further includes an extension layer 405 extending laterally from the boundary 401a of the first semiconductor chip 401. As shown in Fig. 4, the extension layer 405 may extend from all lateral sides of the first semiconductor chip 401 (in the example shown, from all four lateral sides of the chip 401). That is, the extension layer 405 may laterally enclose the first semiconductor chip 401. However, it may also be possible that the extension layer 405 extends only from some of the lateral sides, e.g. from one, two, or three of the four lateral sides of the first semiconductor chip 401, for example from two opposite lateral sides as shown in a plan view 500 in Fig. 5 illustrating another example of a semiconductor device, or from one lateral side as shown in a plan view 600 in Fig. 6 illustrating another example of a semiconductor device.

In general, the extension layer 405 may be formed such that the combined area of the first semiconductor chip 401 and the extension layer 405 may be large enough to fit the size or area of the standardized chip-to-chip interface 403, for example the size or area of a 'wide I/O' logic-memory interface. For example, according to the examples shown in Figs. 4 to 6 the extension layer 405 is formed such that a combined length 408 of the first semiconductor chip 401 and the extension layer 405 is larger than the length of the interface 403.

The extension layer 405 may include or may be composed of a material (or materials) different from the first semiconductor chip 401, for example an insulating material, for example a chip encapsulant material, e.g. a plastic material, e.g. a molding material (mold compound). For example, the molding material (mold compound) may be a composite material consisting of a resin (e.g. epoxy resin) and a filler material (e.g. fused silica).

The extension layer 405 may serve as a fan-out extension (fan-out region) of the first semiconductor chip 401 to accommodate one or more electrically conductive contacts (e.g. pads) to be coupled to one or more electrically conductive contacts (e.g. pads) of the interface 403 that lie outside the chip 401's boundary 401a. In other words, electrically conductive contacts of the interface 403 that would no longer fit onto the semiconductor chip 401 because of the first semiconductor chip 401's small size may now be coupled to electrically conductive contacts disposed over the extension layer 405, and a redistribution layer (not shown in Figs. 4 to 6, see e.g. Figs. 7 to 10) used to provide electrical coupling of those contacts with the first semiconductor chip 401.

In accordance with one or more aspects, a fan-out WLP (eWLB) package may be provided, which may have a single level or, if needed, a multi-level redistribution layer (RDL) with electrically conductive contacts (e.g. contact pads) in the top RDL metallization level. By this approach it becomes possible to place all necessary contacts (e.g. pads) to a standardized chip-to-chip interface (e.g. logic-memory interface, e.g. 'wide I/O' interface (of the memory chip or chip stack)) in the RDL of the chip (e.g. logic chip) either over the fan-out region or over the original chip area. On the original chip (e.g. logic chip) the non-fitting electrically conductive contacts (e.g. non-fitting 'wide I/O' pads) may be shifted or rearranged elsewhere and may be connected by the single- or multi-level RDL wiring, as described herein below with reference to Figs. 7 to 10.

Fig. 7 is a plan view 700 of an example of a semiconductor device, including a redistribution layer 409 configured to reroute interface connections, e.g. electrically conductive contacts, 410 of the standardized chip-to-chip interface 403, disposed outside the boundary 401a of the first semiconductor chip 401 to electrically conductive contacts (e.g. pads) 411a (of the first semiconductor chip 401) inside the boundary 401a of the first semiconductor chip 401. For example, by means of the redistribution layer 409 logic-memory interface connections (e.g. 'wide I/O' interface connections) on a memory chip 404 (or memory chip stack), e.g. a 'wide I/O' DRAM chip, not fitting on a logic chip 401 may be rerouted to electrically conductive contacts (e.g. pads) 411a rearranged or shifted on the logic chip 401. The redistribution layer 409 is disposed over at least one side of the extension layer 405 and the first semiconductor chip 401. The redistribution layer 409 may include or may be composed of an electrically conductive material, for example, a metal or metal alloy such as copper, aluminum, or an alloy containing copper and/or aluminum. The redistribution layer 409 may include one or more electrically conductive contacts (e.g. pads) to be coupled to respective electrical contacts of the chip-to-chip interface 403, and may include one or more conductive traces connecting the electrically conductive contacts (e.g. pads) of the redistribution layer 409 to the electrically conductive contacts (e.g. pads) of the first semiconductor chip 401.

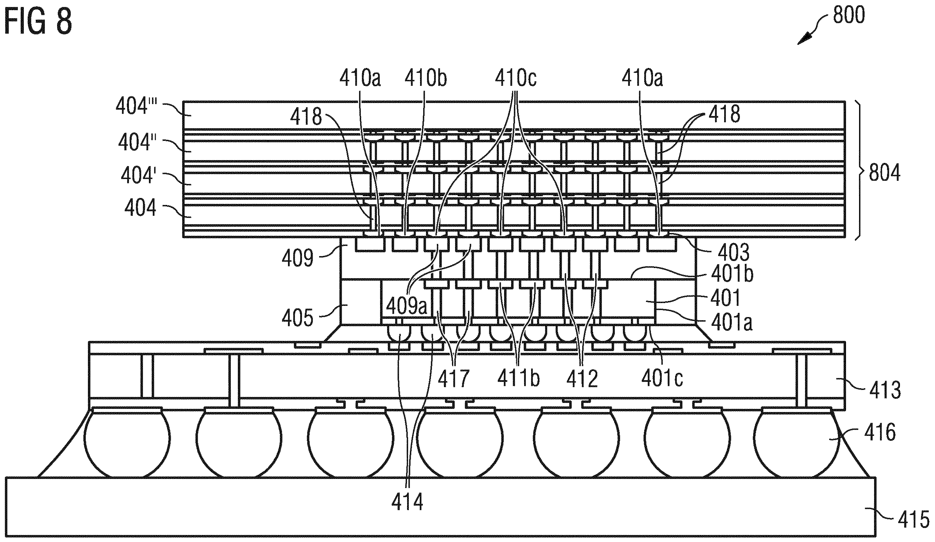

Illustratively, as shown in Fig. 7, not all of the electrically conductive contacts of the standardized chip-to-chip interface 403 fit on the original size or area of the first semiconductor chip 401 as, in this example, the first semiconductor chip 401 is shorter than the interface 403. One or more electrically conductive contacts 410a of the interface 403 lying completely outside the boundary 401a of the first semiconductor chip 401 may be rerouted to one or more electrically conductive contacts 411a lying inside the boundary 401a by means of the redistribution layer 409. It may also be possible to reroute one or more electrically conductive contacts 410b of the interface 403 that lie inside the chip boundary 401a but close to the chip boundary 401a (for example, contacts 410b having a lateral distance of less than or equal to about 100 µm, e.g. less than or equal to about 50 µm, from the chip boundary 401a) to one or more electrically conductive contacts 411a of the first semiconductor chip 401 that are disposed well inside the chip boundary 401a (e.g. contacts 411a having a lateral distance of greater than about 50 µm, e.g. greater than about 100 µm, from the chip boundary 401a), as shown. On the other hand, electrically conductive contacts (e.g. pads) 410c of the interface 403 that lie well within the boundary 401a of the first semiconductor chip 401 may or may not be rerouted and may be coupled to corresponding electrically conductive contacts (e.g. pads) 411b (not shown in Fig. 7, see e.g. Fig. 8) of the first semiconductor chip 401.

Fig. 8 is a cross-sectional view 800 of a semiconductor device, which may be configured as a three-dimensional (3D) logic-memory stack.

The semiconductor device includes the first semiconductor chip 401, which may be configured as a logic chip (e.g. central processing unit (CPU), graphics processing unit (GPU), application processor (AP), base band modem, micro controller, or the like), and the second semiconductor chip 404, which may be configured as a memory chip, e.g. as a DRAM chip, and coupled to the first semiconductor chip 401 via the standardized chip-to-chip interface 403, which may be a logic-memory interface (e.g. a 'wide I/O logic-memory interface). The second semiconductor chip 404 may be part of a chip stack 804, e.g. a memory chip stack, e.g. a 'wide I/O' memory stack, e.g. a DRAM stack, including at least one additional semiconductor chip (e.g. memory chip, e.g. DRAM chip) stacked on top of the second semiconductor chip 404. In the example shown in Fig. 8, three additional semiconductor chips 404', 404", and 404‴ are stacked on top of the second semiconductor chip 404, resulting in a total of four chips, however the number of chips in the stack 804 may be different from four, e.g. two, three, five, six, seven, etc. Alternatively, only the second semiconductor chip 404 may be disposed over the first semiconductor chip 401.

The logic-memory interface (e.g. 'wide I/O' interface) 403 may extend over the original logic chip size. In other words, the interface 403 extends beyond the (lateral) boundary 401a of the first semiconductor chip 401, as shown. An extension layer 405 (e.g. fan-out eWLB extension) may extend laterally from the boundary 401a of the small logic chip 401 to increase the chip area of the logic chip 401. A part of the extension layer 405 may be disposed between the first semiconductor chip 401 and the second semiconductor chip 404, for example over a first side 401b of the logic chip 401 facing the second semiconductor chip 404. The first side 401b may be a back side of the first semiconductor chip 401. That is, the first semiconductor chip 401 may be arranged as in a typical flip chip arrangement with a second side 401c (front side or active side) of the first semiconductor chip 401 facing down (facing away from the interface 403 in this case), e.g. towards a ball grid array as shown in Fig. 8.

A single-level redistribution layer (RDL) 409 may be disposed over the extension layer 405 for rerouting interface connections (e.g. 'wide I/O' connections), e.g. electrically conductive contacts (e.g. pads), 410 (see Fig. 7) of the interface 403 lying outside the boundary 401a of the logic chip 401 to chip areas out of the drawing plane of Fig. 8, e.g. to rearranged or shifted electrically conductive contacts 411 of the first semiconductor chip 401 (see Fig. 7). Alternatively to a single-level RDL, a multi-level RDL may be used.

The redistribution layer 409, or one or more electrically conductive contacts (e.g. pads) 409a of the redistribution layer 409, may be coupled to corresponding electrically conductive contacts (e.g. pads) 411a, 411b of the first semiconductor chip 401 by means of one or more through-vias 412 (e.g. through-encapsulant vias, e.g. through-mold vias (TMVs)) in the extension layer 405. The electrically conductive contact(s) 411a, 411b of the first semiconductor chip 401 coupled to the redistribution layer 409 (or to the electrically conductive contact(s) 409a of the redistribution layer 409) may be disposed over the first side 401b (e.g. back side) of the first semiconductor chip 401 facing the second semiconductor chip 404, as shown. The first semiconductor chip 401 may include one or more through-vias 417 (e.g. through-silicon vias (TSVs)) coupled to the electrically conductive contact(s) 411a, 411b disposed over the first side 401b and extending to the second side 401c (e.g. front side) of the first semiconductor chip 401 opposite the first side 401b.

The chips of the chip stack 804, e.g. 'wide I/O' memory stack, (except for the topmost chip), i.e. the second semiconductor chip 404 and the additional semiconductor chips 404' and 404'', may also include one more through-vias 418 (e.g. through-silicon vias (TSVs)) extending in each case from a front side to a back side of the respective chip 404, 404', 404'' to allow for electrical coupling between the individual chips of the chip stack 804 and thus to the first semiconductor chip 401 via the interface 403.

The through-vias 417 through the first semiconductor chip 401 and the through-vias 418 through the chip stack 804 (e.g. 'wide I/O' memory stack) as well may be located underneath (or above) the respective electrically conductive contacts (e.g. pads) of the interface 403 (e.g. the 'wide I/O' logic/memory interface with 40 µm × 50 µm pad pitch), as shown in Fig. 8.

However, the through-vias 417 may be located elsewhere and the connection between the electrically conductive contacts (e.g. pads) of the interface 403 (e.g. 'wide I/O' interface pads) and the respective through-vias 417 may be provided by a rerouting in the single- or multi-level RDL 409 of the fan-out eWLB package and/or by a back side metallization of the first semiconductor chip 401. By using the rerouting capability of the RDL layers and/or the back side metallization it may be possible to put the through-vias 417 or through-via arrays on any arbitrary and user-defined location on the chips. In addition, by this approach much smaller through-vias (i.e. with smaller diameter) and/or smaller through-via pitches (independent of the interface pad pitch (e.g. 'wide I/O' pad pitch)) may be achieved (for example by using through-via diameters of less than 5 µm and/or through-via pitches of less than 10 µm). By this approach a significant amount of precious chip area may be saved.

As in a typical flip chip arrangement, the first semiconductor chip 401 (e.g. the second side, e.g. front side, 401c of the chip 401) may be coupled to a (e.g. multi-level) ball grid array (BGA) package, including for example, an interposer 413 (e.g. a laminate interposer having one or more metallization or interconnect levels) connected to one or more electrically conductive contacts (e.g. pads) on the second side (e.g. front side) 401c of the first semiconductor chip 401 by means of one or more electrical connectors 414 (e.g. solder bumps (as shown), or metal (e.g. Cu) pillars), and a printed circuit board (PCB) 415 connected to the interposer 413 by means of one or more electrical connectors 416 (e.g. solder bumps, as shown).

Alternatively to the flip chip arrangement where the front side (or active side) of the first semiconductor chip 401 faces the ball grid array (BGA), the semiconductor chip 401 may also be arranged such that its front side (or active side) faces away from the BGA and towards the second semiconductor chip 404 or chip stack 804.

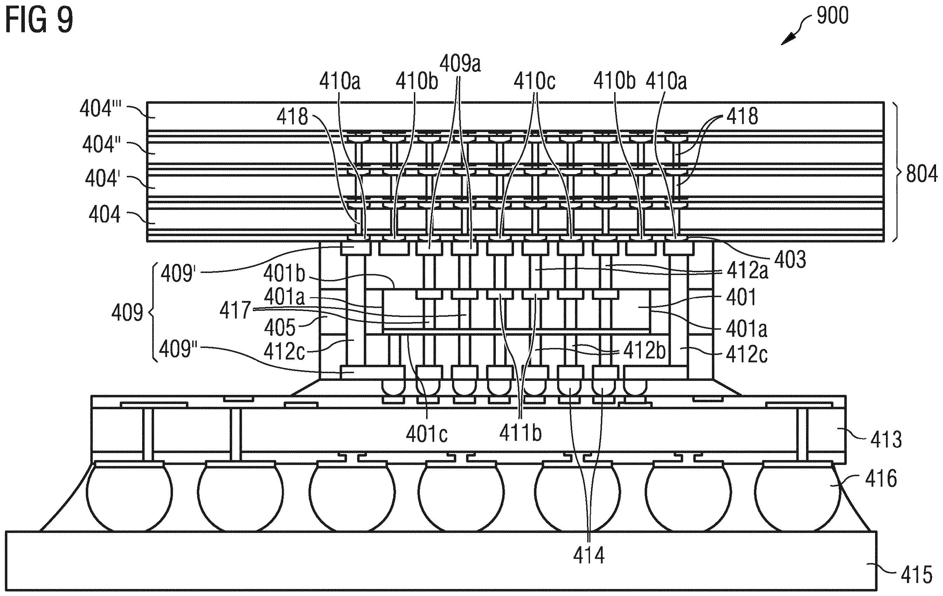

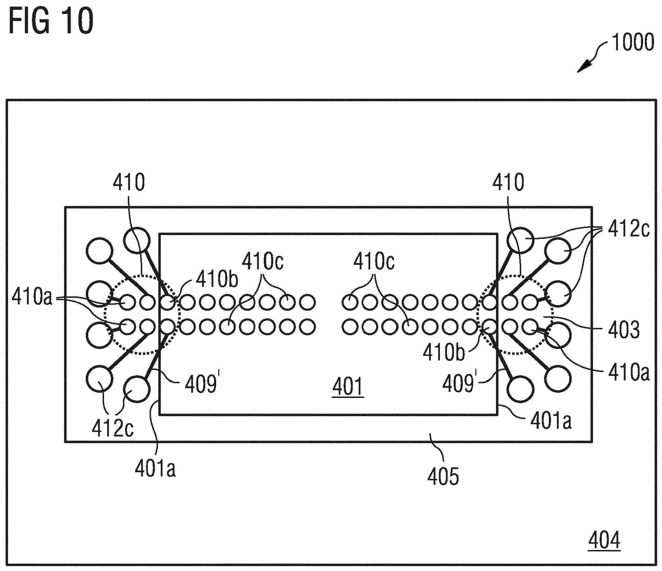

In another example, a double-sided eWLB extension with single or multi-level RDL on both sides may be used. This means that an eWLB RDL may be used on the back side of the first semiconductor chip (e.g. logic chip) connecting to the standardized interface 403, e.g. logic-memory interface, e.g. 'wide I/O memory interface' (as shown in Fig. 8), and additionally on the chip front side to connect to an interposer 413, e.g. BGA laminate, as shown in Figs. 9 and 10.

Fig. 9 and Fig. 10, respectively, show a cross-sectional view 900 and a plan view 1000 of a semiconductor device including a redistribution layer 409 for rerouting interface connections (e.g. electrically conductive contacts, e.g. pads) of the standardized chip-to-chip interface 403, wherein a first portion 409' of the redistribution layer 409 is disposed over the first side (e.g. back side) 401b and a second portion 409'' of the redistribution layer 409 is disposed over the second side (e.g. front side) 401c of the first semiconductor chip 401. The extension layer 405 (e.g. eWLB chip extension) may laterally extend from the boundary 401a of the first semiconductor chip 401, e.g. from all lateral sides of the first semiconductor chip 401, as shown in Fig. 10, alternatively from only some (e.g. one, two, or three) lateral sides of the first semiconductor chip 401. A part of the extension layer 405 may be disposed over the first side 401b of the first semiconductor chip 401 (facing the chip-to-chip interface 403), and a further part of the extension layer 405 may be disposed over the second side 401c of the first semiconductor chip 401. The extension layer 405 may thus at least partially, e.g. fully, enclose the first semiconductor chip 401.

As in the example of Fig. 8, the semiconductor device may be configured as a three-dimensional (3D) logic-memory stack, wherein the first semiconductor chip 401 may be a logic chip and may be coupled (via the chip-to-chip interface 403, e.g. logic-memory interface, e.g. 'wide I/O' interface) to a memory chip stack 804 (e.g. DRAM stack) including the second semiconductor chip 404 and one or more additional semiconductor chips 404', 404", 404‴ which may be configured as memory chips (e.g. DRAM chips). Reference signs that are the same as in Fig. 8 may denote the same elements as there and will not described in detail again here for sake of brevity. Reference is made to the description above.

One or more electrically conductive contacts (e.g. pads) 410 of the standardized interface 403 may be rerouted via the redistribution layer 409. The contacts 410 may include one or more contacts 410a lying at least partially outside, e.g. fully outside, the boundary 401a of the first semiconductor chip 401, and may possibly also include one or more contacts 410b that lie inside the chip boundary 401a but close to the chip boundary 401a, as described above.

One or more through-vias 412c (e.g. through-encapsulant vias, e.g. through-mold vias (TMVs)) may be provided in the extension layer 405 to electrically couple the rerouted contacts 410 (e.g. contacts 410a and/or 410b) to one or more electrically conductive contacts (e.g. pads) of the first semiconductor chip 401 disposed over the second side (e.g. front side) 401c. To this end, the respective through-via(s) 412c may be coupled to the first portion 409' of the redistribution layer 409 disposed over the first side 401b of the first semiconductor chip 401 and to the second portion 409'' of the redistribution layer 409 disposed over the second side 401c of the first semiconductor chip 401, and the second portion 409'' of the redistribution layer 409 may further be coupled to the one or more electrically conductive contacts (e.g. pads) of the first semiconductor chip 401 disposed over the second side 401c of the first semiconductor chip 401, for example by means of one or more through-vias 412b (e.g. through-encapsulant vias, e.g. through-mold vias (TMVs)) disposed in the part of the extension layer 405 that is disposed over the second side 401c of the first semiconductor chip 401, i.e. between the first semiconductor chip 401 and the second portion 409'' of the redistribution layer 409. The second portion 409'' of the redistribution layer 409 (or at least a part of the second portion 409'' of the redistribution layer 409) may further be coupled to the interposer 413, e.g. via one or more electrical connectors 414 such as solder bumps (as shown) or metal pillars (e.g. Cu pillars), to provide electrical coupling of the semiconductor device to external devices.

It also be possible, that one or more of the through-vias 412c leading through the extension layer 405 are coupled to a part of the second portion 409'' of the redistribution layer 409 that may be coupled to the interposer 413 but not to the first semiconductor chip 401. For example, in the example shown Fig. 9, the through-via 412c on the right-hand side of the figure is coupled to a part of the second portion 409'' of the redistribution layer 409 that is coupled to the interposer 413 but not to the first semiconductor chip 401, whereas the through-via 412c on the left-hand side of the figure is coupled to a part of the second portion 409'' of the redistribution layer 409 that is coupled (by means of a through via 412) to the first semiconductor chip 401. Illustratively, it may be possible to lead one or more of the interface connections around the first semiconductor chip 401 (in other words, bypass the first semiconductor chip 401) and couple them directly to the interposer 413 or ball grid array without making electrical contact to the first semiconductor chip 401.

One or more electrically conductive contacts (e.g. pads) 410c of the interface 403 that lie well inside the chip boundary 401a (e.g. having a distance of greater than or equal to about 5 µm, e.g. greater than or equal to about 10 µm, from the chip boundary 401a) may be coupled to one or more electrically conductive contacts 411b of the first semiconductor chip 401 that are disposed over the first side (e.g. back side) 401b of the first semiconductor chip 401, e.g. by means of one or more through-vias (e.g. TMVs) 412a disposed in the part of the extension layer 405 that is disposed over the first side (e.g. back side) 401b of the first semiconductor chip 401.

Illustratively, Figs. 9 and 10 show an example of a semiconductor device wherein a standardized chip-to-chip interface 403 (e.g. logic-memory interface, e.g. 'wide I/O' interface) extends over the original chip size of a first semiconductor chip (e.g. logic chip) 401, an extension layer 405 (e.g. fan-out eWLB extension) of the first semiconductor chip (e.g. (small) logic chip) 401 having a single-level RDL 409 on both sides (i.e. on a chip back side 401b connecting to the interface (e.g. 'wide I/O' interface) 403 and on a chip front side (e.g. over back-end-of-line (BEOL) layers) connects to an interposer (e.g. laminate interposer) 413 and to the first semiconductor chip (e.g. logic chip) 401, and through-vias (e.g. through-mold vias (TMVs)) 412c couple electrically conductive contacts of the interface 403 (e.g. 'wide I/O' interface pads) via the redistribution layer 409 (e.g. eWLB RDL) (on back side 401b and front side 401c) with the active side (e.g. on-chip interconnect BEOL) of the chip (see left through-via 412c in Fig. 9) or directly with the interposer (e.g. laminate interposer) 413 bypassing the first semiconductor chip (e.g. logic chip) 401 (see right through-via 412c in Fig. 9).

The examples described herein above in connection with the figures mainly discuss the case that only one lateral dimension (e.g. the length) of the first semiconductor chip is smaller than the respective dimension of the standardized chip-to-chip interface. However, as will be readily understood, one or more aspects described herein may equally apply to the case where more than one lateral dimension of the first semiconductor chip (e.g. length and width) is smaller than the respective dimension of the standardized chip-to-chip interface. For example, if both a length and a width of the first semiconductor chip are smaller than a respective length and width of the standardized interface the extension layer (e.g. eWLB fan-out region) may be configured to increase the original chip area such that the interface fits onto the chip having the extension.

The extension layer and redistribution layer may, for example, be formed using known manufacturing processes for manufacturing eWLB packages.

## Claims

1. A semiconductor device, comprising:
a first semiconductor chip (401);
a second semiconductor chip (404), wherein the first semiconductor chip (401) has at least one contact to be electrically coupled to the second semiconductor chip (404) having an interface (403) with standardized geometric dimensions, and wherein the second semiconductor chip (404) is electrically coupled to the first semiconductor chip (401) via the interface (403);
an extension layer (405) extending laterally from a boundary (401a) of the first semiconductor chip (401), wherein a combined lateral dimension of the first semiconductor chip (401) and the extension layer (405) along the at least one direction is greater than or equal to the lateral dimension of the interface (403) along the at least one direction; and
a redistribution layer (409) disposed over at least one side of the extension layer (405) and the first semiconductor chip (401), wherein the redistribution layer (409) is configured to electrically couple at least one contact of the first semiconductor chip (401) to at least one contact of the interface (403), **characterized in that**:
at least a part of the interface (403) extends laterally beyond the boundary (401a) of the first semiconductor chip (401); and
a lateral dimension (406) of the first semiconductor chip (401) along at least one direction is smaller than a lateral dimension (407) of the interface (403) along the at least one direction.

2. The semiconductor device of claim 1, wherein the at least one contact of the interface (403) is disposed at least partially outside the boundary (401a) of the first semiconductor chip (401).

3. The semiconductor device of claim 1, wherein the standardized interface (403) is a standardized chip-to-chip interface (403).

4. The semiconductor device of claim 2, wherein the redistribution layer (409) comprises at least one contact configured to couple to the at least one contact of the interface (403) disposed at least partially outside the boundary (401a) of the first semiconductor chip (401).

5. The semiconductor device of claim 4, wherein the redistribution layer (409) further comprises at least one contact configured to couple to at least one contact of the interface (403) disposed inside the boundary (401a) of the first semiconductor chip (401).

6. The semiconductor device of claim 1, wherein the redistribution layer (409) is disposed over a back side (401b) of the first semiconductor chip (401).

7. The semiconductor device of claim 5, wherein the extension layer (405) is disposed over the back side (401b) of the first semiconductor chip (401) between the first semiconductor chip (401) and the redistribution layer (409).

8. The semiconductor device of claim 7, wherein the extension layer (405) additionally comprises at least one through-via electrically coupling at least one contact of the first semiconductor chip (401) with the redistribution layer (409).

9. The semiconductor device of claim 1, wherein the redistribution layer (409) comprises a first portion disposed over a first side of the first semiconductor chip (401) and a second portion disposed over a second side of the first semiconductor chip (401) opposite the first side; or
wherein the extension layer (405) is composed of material different from the first semiconductor chip (401); or
wherein the extension layer (405) at least partially encapsulates the first semiconductor chip (401).

10. The semiconductor device of claim 9,
wherein the first portion of the redistribution layer (409) comprises at least one contact configured to couple to the at least one contact of the interface (403) disposed at least partially outside the boundary (401a) of the first semiconductor chip (401),
wherein the extension layer (405) comprises at least one through-via electrically coupling the first portion of the redistribution layer (409) with the second portion of the redistribution layer (409).

11. The semiconductor device of claim 10,
wherein the first semiconductor chip (401) comprises at least one contact disposed over the second side of the first semiconductor chip (401) and electrically coupled with the second portion of the redistribution layer (409), preferably wherein the first side is a back side (401b) of the first semiconductor chip (401) and the second side is a front side (401c) of the first semiconductor chip (401).

12. The semiconductor device of claim 1,
wherein the first semiconductor chip (401) is a logic chip and the second semiconductor chip (404) is a memory chip; or
further comprising at least one additional semiconductor chip disposed over a side of the second semiconductor chip (404) facing away from the first semiconductor chip (401), and electrically coupled to the second semiconductor chip (404).

13. The semiconductor device of claim 1:
wherein the first semiconductor chip (401) has a first plurality of contacts;
wherein the redistribution layer (409) has a second plurality of contacts electrically coupled to the first plurality of contacts,
wherein at least one contact of the second plurality of contacts is disposed at least partially outside the lateral boundary of the first semiconductor chip (401),
wherein the second plurality of contacts is arranged in accordance with a predetermined interface standard.

14. The semiconductor device of claim 13, further comprising:
the second semiconductor chip (404) having a third plurality of contacts arranged in accordance with the predetermined interface standard,
wherein the third plurality of contacts is in contact with the second plurality of contacts, preferably
wherein the first semiconductor chip (401) is a logic chip and the second semiconductor chip (404) is a memory chip, and
wherein the predetermined interface standard is a logic-memory interface standard, and preferably also wherein the extension layer (405) comprises at least one through-via electrically coupling at least one contact of the first plurality of contacts to at least one contacts of the second plurality of contacts.

## Patentansprüche

1. Halbleitervorrichtung, die Folgendes umfasst:
einen ersten Halbleiterchip (401);
einen zweiten Halbleiterchip (404), wobei der erste Halbleiterchip (401) mindestens einen Kontakt aufweist, um elektrisch mit dem zweiten Halbleiterchip (404) gekoppelt zu werden, der eine Schnittstelle (403) mit standardisierten geometrischen Abmessungen aufweist, und wobei der zweite Halbleiterchip (404) über die Schnittstelle (403) elektrisch mit dem ersten Halbleiterchip (401) gekoppelt ist;
eine Erweiterungsschicht (405), die sich lateral von einer Grenze (401a) des ersten Halbleiterchips (401) erstreckt, wobei eine kombinierte laterale Abmessung des ersten Halbleiterchips (401) und der Erweiterungsschicht (405) entlang der mindestens einen Richtung größer oder gleich der lateralen Abmessung der Schnittstelle (403) entlang der mindestens einen Richtung ist; und
eine Umverteilungsschicht (409), die über mindestens einer Seite der Erweiterungsschicht (405) und des ersten Halbleiterchips (401) angeordnet ist, wobei die Umverteilungsschicht (409) dazu ausgelegt ist, mindestens einen Kontakt des ersten Halbleiterchips (401) elektrisch mit mindestens einem Kontakt der Schnittstelle (403) zu koppeln, **dadurch gekennzeichnet, dass**:
sich mindestens ein Teil der Schnittstelle (403) lateral über die Grenze (401a) des ersten Halbleiterchips (401) hinaus erstreckt; und
eine laterale Abmessung (406) des ersten Halbleiterchips (401) entlang mindestens einer Richtung kleiner als eine laterale Abmessung (407) der Schnittstelle (403) entlang der mindestens einen Richtung ist.

2. Halbleitervorrichtung nach Anspruch 1, wobei der mindestens eine Kontakt der Schnittstelle (403) mindestens teilweise außerhalb der Grenze (401a) des ersten Halbleiterchips (401) angeordnet ist.

3. Halbleitervorrichtung nach Anspruch 1, wobei die standardisierte Schnittstelle (403) eine standardisierte Chip-zu-Chip-Schnittstelle (403) ist.

4. Halbleitervorrichtung nach Anspruch 2, wobei die Umverteilungsschicht (409) mindestens einen Kontakt umfasst, der zur Kopplung mit dem mindestens einen Kontakt der Schnittstelle (403) ausgelegt ist, der mindestens teilweise außerhalb der Grenze (401a) des ersten Halbleiterchips (401) angeordnet ist.

5. Halbleitervorrichtung nach Anspruch 4, wobei die Umverteilungsschicht (409) ferner mindestens einen Kontakt umfasst, der zur Kopplung mit mindestens einem Kontakt der Schnittstelle (403) ausgelegt ist, der innerhalb der Grenze (401a) des ersten Halbleiterchips (401) angeordnet ist.

6. Halbleitervorrichtung nach Anspruch 1, wobei die Umverteilungsschicht (409) über einer Rückseite (401b) des ersten Halbleiterchips (401) angeordnet ist.

7. Halbleitervorrichtung nach Anspruch 5, wobei die Erweiterungsschicht (405) über der Rückseite (401b) des ersten Halbleiterchips (401) zwischen dem ersten Halbleiterchip (401) und der Umverteilungsschicht (409) angeordnet ist.

8. Halbleitervorrichtung nach Anspruch 7, wobei die Erweiterungsschicht (405) zusätzlich mindestens eine Durchkontaktierung umfasst, die mindestens einen Kontakt des ersten Halbleiterchips (401) elektrisch mit der Umverteilungsschicht (409) koppelt.

9. Halbleitervorrichtung nach Anspruch 1, wobei die Umverteilungsschicht (409) einen ersten Teil, der über einer ersten Seite des ersten Halbleiterchips (401) angeordnet ist, und einen zweiten Teil, der über einer zweiten Seite des ersten Halbleiterchips (401) gegenüber der ersten Seite angeordnet ist, umfasst; oder
wobei die Erweiterungsschicht (405) aus einem Material besteht, das sich von dem ersten Halbleiterchip (401) unterscheidet; oder
wobei die Erweiterungsschicht (405) den ersten Halbleiterchip (401) zumindest teilweise einkapselt.

10. Halbleitervorrichtung nach Anspruch 9,
wobei der erste Teil der Umverteilungsschicht (409) mindestens einen Kontakt umfasst, der zur Kopplung mit dem mindestens einen Kontakt der Schnittstelle (403) ausgelegt ist, der mindestens teilweise außerhalb der Grenze (401a) des ersten Halbleiterchips (401) angeordnet ist,
wobei die Erweiterungsschicht (405) mindestens eine Durchkontaktierung umfasst, die den ersten Teil der Umverteilungsschicht (409) elektrisch mit dem zweiten Teil der Umverteilungsschicht (409) koppelt.

11. Halbleitervorrichtung nach Anspruch 10,
wobei der erste Halbleiterchip (401) mindestens einen Kontakt umfasst, der über der zweiten Seite des ersten Halbleiterchips (401) angeordnet und elektrisch mit dem zweiten Teil der Umverteilungsschicht (409) gekoppelt ist, wobei vorzugsweise die erste Seite eine Rückseite (401b) des ersten Halbleiterchips (401) ist und die zweite Seite eine Vorderseite (401c) des ersten Halbleiterchips (401) ist.

12. Halbleitervorrichtung nach Anspruch 1,
wobei der erste Halbleiterchip (401) ein Logikchip ist und der zweite Halbleiterchip (404) ein Speicherchip ist; oder
ferner umfassend mindestens einen zusätzlichen Halbleiterchip, der über einer von dem ersten Halbleiterchip (401) abgewandten Seite des zweiten Halbleiterchips (404) angeordnet und elektrisch mit dem zweiten Halbleiterchip (404) gekoppelt ist.

13. Halbleitervorrichtung nach Anspruch 1:
wobei der erste Halbleiterchip (401) eine erste Vielzahl von Kontakten aufweist;
wobei die Umverteilungsschicht (409) eine zweite Vielzahl von Kontakten aufweist, die elektrisch mit der ersten Vielzahl von Kontakten gekoppelt ist,
wobei mindestens ein Kontakt der zweiten Vielzahl von Kontakten mindestens teilweise außerhalb der lateralen Grenze des ersten Halbleiterchips (401) angeordnet ist,
wobei die zweite Vielzahl von Kontakten gemäß einem vorbestimmten Schnittstellenstandard angeordnet ist.

14. Halbleitervorrichtung nach Anspruch 13, die ferner Folgendes umfasst:
der zweite Halbleiterchip (404) weist eine dritte Vielzahl von Kontakten auf, die gemäß dem vorbestimmten Schnittstellenstandard angeordnet sind,
wobei die dritte Vielzahl von Kontakten mit der zweiten Vielzahl von Kontakten in Kontakt steht, vorzugsweise
wobei der erste Halbleiterchip (401) ein Logikchip ist und der zweite Halbleiterchip (404) ein Speicherchip ist und
wobei der vorbestimmte Schnittstellenstandard ein Logik-Speicher-Schnittstellenstandard ist, und wobei vorzugsweise außerdem die Erweiterungsschicht (405) mindestens eine Durchkontaktierung umfasst, die mindestens einen Kontakt der ersten Vielzahl von Kontakten elektrisch mit mindestens einem Kontakt der zweiten Vielzahl von Kontakten koppelt.

## Revendications

1. Dispositif à semi-conducteur, comprenant :
une première puce à semi-conducteur (401) ;
une deuxième puce à semi-conducteur (404), la première puce à semi-conducteur (401) présentant au moins un contact destiné à être couplé électriquement à la deuxième puce à semi-conducteur (404) présentant une interface (403) avec des dimensions géométriques normalisées, et la deuxième puce à semi-conducteur (404) étant couplée électriquement à la première puce à semi-conducteur (401) via l'interface (403) ;
une couche d'extension (405) s'étendant latéralement à partir d'une limite (401a) de la première puce à semi-conducteur (401), une dimension latérale combinée de la première puce à semi-conducteur (401) et de la couche d'extension (405) le long de l'au moins une direction étant supérieure ou égale à la dimension latérale de l'interface (403) le long de l'au moins une direction ; et
une couche de redistribution (409) disposée sur au moins un côté de la couche d'extension (405) et de la première puce à semi-conducteur (401), la couche de redistribution (409) étant configurée pour coupler électriquement au moins un contact de la première puce à semi-conducteur (401) à au moins un contact de l'interface (403), **caractérisée en ce que** :
au moins une partie de l'interface (403) s'étendant latéralement au-delà de la limite (401a) de la première puce à semi-conducteur (401) ; et
une dimension latérale (406) de la première puce à semi-conducteur (401) le long d'au moins une direction étant inférieure à une dimension latérale (407) de l'interface (403) le long de l'au moins une direction.

2. Dispositif à semi-conducteur selon la revendication 1, dans lequel l'au moins un contact de l'interface (403) est disposé au moins partiellement à l'extérieur de la limite (401a) de la première puce à semi-conducteur (401).

3. Dispositif à semi-conducteur selon la revendication 1, dans lequel l'interface normalisée (403) est une interface (403) puce à puce normalisée.

4. Dispositif à semi-conducteur selon la revendication 2, dans lequel la couche de redistribution (409) comprend au moins un contact configuré pour se coupler à l'au moins un contact de l'interface (403) disposé au moins partiellement à l'extérieur de la limite (401a) de la première puce à semi-conducteur (401).

5. Dispositif semi-conducteur selon la revendication 4, dans lequel la couche de redistribution (409) comprend en outre au moins un contact configuré pour se coupler à au moins un contact de l'interface (403) disposé à l'intérieur de la limite (401a) de la première puce à semi-conducteur (401).

6. Dispositif à semi-conducteur selon la revendication 1, dans lequel la couche de redistribution (409) est disposée sur un côté arrière (401b) de la première puce à semi-conducteur (401).

7. Dispositif à semi-conducteur selon la revendication 5, dans lequel la couche d'extension (405) est disposée sur le côté arrière (401b) de la première puce à semi-conducteur (401) entre la première puce à semi-conducteur (401) et la couche de redistribution (409).

8. Dispositif à semi-conducteur selon la revendication 7, dans lequel la couche d'extension (405) comprend additionnellement au moins un trou traversant couplant électriquement au moins un contact de la première puce à semi-conducteur (401) avec la couche de redistribution (409).

9. Dispositif à semi-conducteur selon la revendication 1, dans lequel la couche de redistribution (409) comprend une première partie disposée sur un premier côté de la première puce à semi-conducteur (401) et une deuxième partie disposée sur un deuxième côté de la première puce à semi-conducteur (401) opposé au premier côté ; ou
dans lequel la couche d'extension (405) est composée d'un matériau différent de celui de la première puce à semi-conducteur (401) ; ou
la couche d'extension (405) encapsulant au moins partiellement la première puce à semi-conducteur (401).

10. Dispositif à semi-conducteur selon la revendication 9,
dans lequel la première partie de la couche de redistribution (409) comprend au moins un contact configuré pour se coupler à l'au moins un contact de l'interface (403) disposé au moins partiellement à l'extérieur de la limite (401a) de la première puce à semi-conducteur (401),
la couche d'extension (405) comprenant au moins un trou traversant couplant électriquement la première partie de la couche de redistribution (409) à la deuxième partie de la couche de redistribution (409).

11. Dispositif à semi-conducteur selon la revendication 10,
la première puce à semi-conducteur (401) comprend au moins un contact disposé sur le deuxième côté de la première puce à semi-conducteur (401) et couplé électriquement à la deuxième partie de la couche de redistribution (409), de préférence le premier côté étant un côté arrière (401b) de la première puce à semi-conducteur (401) et le deuxième côté étant un côté avant (401c) de la première puce à semi-conducteur (401).

12. Dispositif à semi-conducteur selon la revendication 1,
la première puce à semi-conducteur (401) étant une puce logique et la deuxième puce à semi-conducteur (404) étant une puce mémoire ; ou
comprenant en outre au moins une puce à semi-conducteur supplémentaire disposée sur un côté de la deuxième puce à semi-conducteur (404) orienté dans une direction opposée à la première puce à semi-conducteur (401), et couplée électriquement à la deuxième puce à semi-conducteur (404).

13. Dispositif à semi-conducteur selon la revendication 1 :
la première puce à semi-conducteur (401) présentant une première pluralité de contacts ;
la couche de redistribution (409) présentant une deuxième pluralité de contacts couplés électriquement à la première pluralité de contacts,
au moins un contact de la deuxième pluralité de contacts étant disposé au moins partiellement à l'extérieur de la limite latérale de la première puce à semi-conducteur (401),
la deuxième pluralité de contacts étant agencée conformément à une norme d'interface prédéterminée.

14. Dispositif à semi-conducteur selon la revendication 13, comprenant en outre :
la deuxième puce à semi-conducteur (404) présentant une troisième pluralité de contacts agencés conformément à la norme d'interface prédéterminée,
la troisième pluralité de contacts étant de préférence en contact avec la deuxième pluralité de contacts,
la première puce à semi-conducteur (401) étant une puce logique et la deuxième puce à semi-conducteur (404) étant une puce mémoire ; et
la norme d'interface prédéterminée étant une norme d'interface logique-mémoire, et de préférence également la couche d'extension (405) comprenant au moins un trou traversant couplant électriquement au moins un contact de la première pluralité de contacts à au moins un contact de la deuxième pluralité de contacts.
